# EUROPEAN PATENT SPECIFICATION

(11) **EP 4 616 531 B1**
(45) Date of publication and mention of the grant of the patent: **04.03.2026**
(21) Application number: 23809352.0
(22) Date of filing: 10.11.2023
(51) Int. Cl.: H03G 5/00, H03G 5/02, H04R 3/04

(54) **EQUALIZER CONTROL**
ENTZERRERSTEUERUNG
COMMANDE D'ÉGALISEUR

(30) Priority: 11.11.2022 SE 2251320
(43) Date of publication of application: 17.09.2025
(73) Proprietor: Audiodo AB (publ), 211 13 Malmö (SE)
(72) Inventor: LUNDBÄCK, Jonas, 235 35 Vellinge (SE); PHILIPSSON, John, 211 15 Malmö (SE); MARTINSON, Roger, 216 41 Limhamn (SE); FRANSSON, Peter, 211 30 Malmö (SE)
(74) Representative: Ström & Gulliksson AB
(86) International application number: PCT/SE2023/051141
(87) International publication number: WO 2024/102060

(56) References cited:
- EP-A1- 1 182 540
- GB-A- 2 357 409
- US-A1- 2003 035 555
- US-A1- 2010 202 630
- US-A1- 2011 096 933

## Description

### TECHNICAL FIELD

The present invention relates to audio equalization and more precisely to a method of controlling a parametric equalizer.

### BACKGROUND

Access to audio in all its forms have increased greatly with the introduction of portable electronics equipment such as the Walkman^{®} and later mobile phones. An audio book, a favorite song or an interesting podcast is always within reach.

This has led to several innovations within audio playback devices and sound control. One revolutionary innovation is the ability to provide personal sound to a user of a playback device. This comprises adapting the sound played to compensate for any hearing deviations of the user.

Prior to the personal sound, classical equalizers have been available allowing the user to configure and shape a filter based on his or her preferences. A typical loudness filter may, for instance, be employed at low frequencies to ensure a consistent audio experience also at lower playback volumes. However, these equalizers are commonly graphical equalizer urging the user to control a gain at a number of predefined frequency ranges making the configuration blunt and coarse. More advanced equalizers, e.g. parametric equalizers, allow much greater freedom of control but are comparably complex to control and will generally be left at predefined settings rather than personalized based on taste in audio. EP 1 182 540 A1 (SONY INT EUROPE GMBH [DE]) 27 February 2002 (2002-02-27), US 2011/096933 A1 (EASTTY PETER CHARLES [GB]) 28 April 2011 (2011-04-28), US 2010/202630 A1 (LINDAHL ARAM [US] ET AL) 12 August 2010 (2010-08-12) and GB 2 357 409 A (SONY UK LTD [GB]) 20 June 2001 (2001-06-20) are considered to disclose most relevant state of the art with regards to the present application.

### SUMMARY

It is in view of the above considerations and others that the various embodiments of this disclosure have been made. The present disclosure therefor recognizes the fact that there is a need for alternatives to (e.g. improvement of) the existing art described above. It is an object of some embodiments to solve, mitigate, alleviate, or eliminate at least some of the above or other disadvantages.

An object of the present disclosure is to provide a new type of control for an audio equalizer which is improved over prior art and which eliminates or at least mitigates the drawbacks discussed above. More specifically, an object of the invention is to provide a control method that allows everyday people to control advanced parametric audio equalizers and enjoy the improved and customized audio offered by them. These objects are achieved by the technique set forth in the appended independent claims with preferred embodiments defined in the dependent claims related thereto.

According to a first aspect of the invention, a method of controlling an audio equalizer (EQ) is presented.
The audio EQ is arranged to process an audio stream. The method comprises obtaining a number of EQ control indicators for control of the audio EQ. Each EQ control indicator comprises a frequency and a gain. The method further comprises curve fitting between the EQ control indicators and thereby providing a polynomial EQ function describing a preferred gain versus frequency behavior of the audio EQ. A number of EQ control parameters are determined based on the polynomial EQ function. Each EQ control parameter comprises a frequency and a gain. The number of EQ control indicators is at least two, and the number of EQ control parameters is greater than the number of EQ control indicators. The EQ control parameters are provided for control of the audio EQ.

In one variant, the number of EQ control parameters are equal to a number of frequency bands of the audio EQ and the frequency of each EQ control parameter is associated with a corresponding frequency band of the audio EQ. This is beneficial as processing power is not wasted by determining more EQ control parameters than are needed, or by having to interpolate between EQ control parameters if too few are determined.

In one variant, the audio EQ is a parameteric audio EQ and at least one of the EQ control parameters comprises a bandwidth and/or a Q-value. This is beneficial as the polynomial EQ function may be used for adapting also the bandwidth and/or the Q-value which further improves the sound quality provided by the EQ and reduces a risk of abrupt amplitude changes between adjacent bands of the EQ. That is to say, the bandwidth of a control parameter may be determined based on a derivative (frequency derivative) of the polynomial EQ function. Preferably, if the polynomial EQ function describe a comparably high change in gain, i.e. large (positive or negative) derivative, the bandwidth may be reduced, and if the polynomial EQ function describe a comparably low change in gain, i.e. low (positive or negative) or zero derivative, the bandwidth may be increased.

In one variant, the polynomial EQ function is a polynomial function of second order. This is beneficial as it provides a reasonable trade-off between smoothness/fit (with regards to the EQ control indicators) of the polynomial EQ function and computational complexity.

According to the first aspect of the invention, the method further comprises, prior to determining the number of EQ control parameters, obtaining a tilt indicator. The tilt indicator indicate an additional linear gain inclination across the polynomial EQ function, and applying the tilt indicator to the polynomial EQ function. This is beneficial as it present a simple and straight-forward means of customizing playback of audio with regards to e.g. bass vs. treble response.

In one variant, the method further comprises, preferably prior to determining the number of EQ control parameters, obtaining a power frequency spectrum of average music audio and processing the polynomial EQ function based on the power frequency spectrum. This is beneficial as it allows the EQ processing to be activated/deactivated or tuned without changing a total sound pressure level (SPL) of the audio played. That is to say, the user will not experience significant changed in volume when activating/deactivating or tuning the EQ.

In one variant, the method further comprises, preferably prior to determining the number of EQ control parameters, obtaining a playback SPL indicator indicative of a SPL used for playback of the audio stream and processing the polynomial EQ function based on equal loudness contours.

In one variant, the EQ control indicators are provided by a graphical user interface (GUI) of a user equipment, UE, and the frequency and the gain of the EQ control indicators are controllable via the GUI. This is beneficial as a GUI offers a intuitive and simple way of controlling the EQ control indicators. Preferably the GUI is presented on a touchscreen.

In one variant, the tilt indicator is controllable via the GUI.

In one variant, the method further comprises, preferably prior to curve fitting between the EQ control indicators, providing the polynomial EQ function for visualization on the GUI. This further improves the intuitiveness of the GUI as the user is allowed to see an indication of how the EQ control indicators are presented to the EQ.

In a second aspect of the invention, a processor circuit is presented. The processor circuit is operatively connected to an audio EQ arranged to process an audio stream. The processor circuit is configured to cause obtainment of a number of EQ control indicators for control of the audio EQ, each EQ control indicator comprising a frequency and a gain. The processor circuit is further configured to cause curve fitting between the EQ control indicators and thereby causing provisioning of a polynomial EQ function describing a preferred gain versus frequency behavior of the audio EQ. Further to this, the processor circuit is configured to cause obtainment of a tilt indicator (T) indicating an additional linear gaininclination across the polynomial EQ function (p), and application of the tilt indicator (T) to the polynomial EQ function (p) and determining of a number of EQ control parameters based on the polynomial EQ function. Each EQ control parameter comprises a frequency and a gain. The number of EQ control indicators is at least two, and the number of EQ control parameters is greater than the number of EQ control indicators. Also, the processor circuit is configured to cause provisioning of the EQ control parameters for control of the audio EQ.

In one variant, the processor circuit is further configured to cause execution of the method according to first aspect.

In a third aspect, an audio system is presented. The audio system comprises the processor circuit of the second aspect, an audio speaker arrangement and an audio EQ arranged to filter an audio stream for playback by the audio speaker arrangement. The processor circuit is operatively connected to the audio EQ and the audio EQ is operatively connected to the audio speaker arrangement.

In one variant, the processor circuit is comprised in a user equipment of the audio system and the audio EQ is comprised in the audio speaker arrangement. This is beneficial as, if e.g., the audio speaker arrangement is a wireless audio speaker arrangement, the processing (e.g., filtering) of the audio stream is performed as close as possible to a speaker. Further, in many e.g., Bluetooth audio speaker arrangements audio speaker arrangement, a processor circuit of the audio speaker arrangement comprises a configurable EQ.

In a fourth aspect, a computer program product storing a computer program comprising program instructions readable by a processor circuit and configured to cause, when run by the processor circuit, the processor circuit to perform the method according to the first aspect.

### BRIEF DESCRIPTION OF THE DRAWINGS

Embodiments of the invention will be described in the following; references being made to the appended diagrammatical drawings which illustrate non-limiting examples of how the inventive concept can be reduced into practice.
Figs. 1a-b are gain versus frequency plots for audio equalizers according to some embodiments of the present disclosure;
Figs. 2a-d are gain versus frequency plots describing how EQ control indicators are associated with bands of an EQ according to some embodiments of the present disclosure;
Figs. 3a-b are gain versus frequency plots describing how a tilt indicator may be applied to EQ control indicators according to some embodiments of the present disclosure;
Fig. 4 is a schematic view of an audio system according to some embodiments of the present disclosure;
Fig. 5 is a block view of an audio speaker arrangement according to some embodiments of the present disclosure;
Fig. 6 is a block view of an electronic device according to some embodiments of the present disclosure;
Fig. 7 is a schematic view of a method of controlling an audio equalizer according to some embodiment of the present disclosure;
Fig. 8 is a schematic view of a computer program product according to some embodiment of the present disclosure; and
Figs. 9a-d are schematic views indicating loadability of a computer program product according to some embodiment of the present disclosure.

### DETAILED DESCRIPTION

Hereinafter, certain embodiments will be described more fully with reference to the accompanying drawings. The invention may, however, be embodied in many different forms and should not be construed as limited to the embodiments set forth herein; rather, these embodiments are provided by way of example so that this disclosure will be thorough and complete, and will fully convey the scope of the invention, such as it is defined in the appended claims, to those skilled in the art.

The term "coupled" is defined as connected, although not necessarily directly, and not necessarily mechanically. Similarly, the term "connected", or "operatively connected", is defined as connected, although not necessarily directly, and not necessarily mechanically. Two or more items that are "coupled" or "connected" may be integral with each other. The terms "a" and "an" are defined as one or more unless this disclosure explicitly requires otherwise. The terms "substantially", "approximately" and "about" are defined as largely, but not necessarily wholly what is specified, as understood by a person of ordinary skill in the art. The terms "comprise" (and any forms thereof), "have" (and any forms thereof), "include" (and any form thereof) and "contain" (and any forms thereof) are open-ended linking verbs. As a result, a method that "comprises", "has", "includes" or "contains" one or more steps, possesses those one or more steps, but is not limited to possessing only those one or more steps.

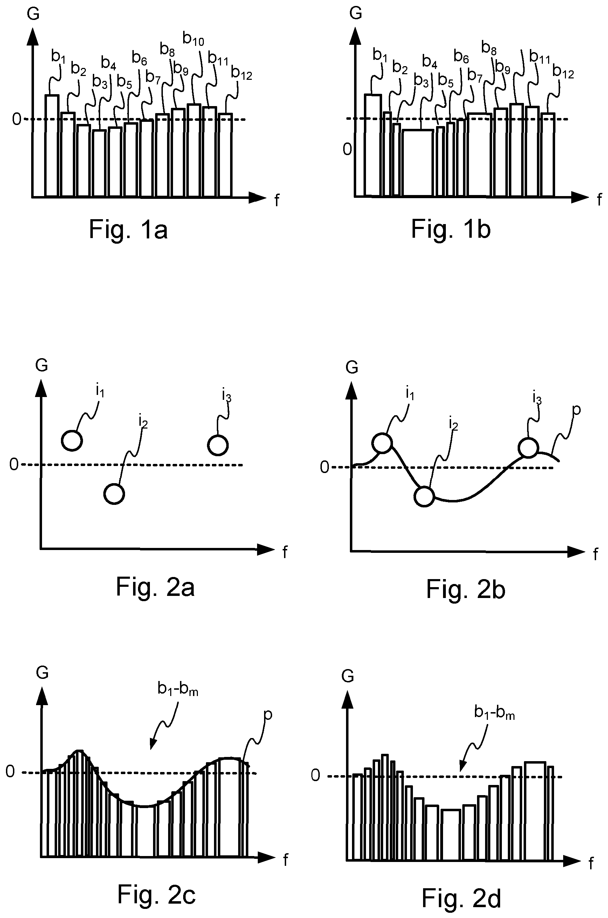

In Fig. 1a, settings for a 12-band equalized (EQ) is shown. Each band b₁, ..., b₁₂ of the EQ is indicated by a rectangular square, which's width is indicative of the bandwidth of the band b₁, ..., b₁₂, and which's height is indicative of the gain G to be applied within the associated bandwidth. The gain G of each band b₁, ..., b₁₂ of the 12-band EQ may be controlled by means of a respective control e.g. a slider or a bar. This means that each band b₁, ..., b₁₂ is fixed in frequency f and may only be configured with regards to its gain G. Such control of an EQ is commonplace and may be referred to as a graphical equalizer. Tuning of a 12-band graphical EQ is something that most users comprehend and consider feasible, control interfaces for EQs with a limited number of bands b₁, ..., b₁₂ were generally provided on stereo systems and the like allowing the user to tune and color the sound based on preference.

For the present disclosure, when gain G is illustrated as a function of frequency f, such as in Fig. 1a, the frequency axis is logarithmic. This means that an absolute bandwidth in Hz of a higher band, e.g. the highest band b₁₂, is wider than a bandwidth of a lower band, e.g. the lowest band b₁ although the width of the corresponding rectangular shapes illustrating the bands b₁, ..., b₁₂ are the same.

In. Fig. 1b, another 12-band EQ is shown. The 12 bands b₁, ..., b₁₂ of the EQ in Fig. 1b are shown in the corresponding gain G versus frequency f graph as the bands b₁, ..., b₁₂ of Fig. 1a. In Fig. 1b, the bandwidth of each band b₁, ..., b₁₂ is not increasing strictly exponentially as in Fig. 1a (the frequency-axis is logarithmic), but is configurable. This introduces one more degree of freedom in tuning of the EQ, and in further variants (will be detailed in the following) also a frequency f of each band b₁, ..., b₁₂ may be tunable. This further increases the complexity of controlling the EQ. EQs where the bands b₁, ..., b₁₂ are controllable with regards to frequency f, gain G and bandwidth Q-value are generally referenced parametric EQs. Such EQs provide the most tunability and customization of the processing (filtering) provided by the EQ. Parametric EQs are generally computer implemented with a large number of bands (any where from 4 bands and up) making them comparably complex to tune and not readily available or feasible to control by most people.

As indicated, the large set of parameters (high degree of freedom) in a parametric EQ is making tuning of the EQ complex and cumbersome. Knowledge of how a single isolated parameter may affect the sound equalization may be self-explanatory. However, how to achieve a desired characteristic sound equalization by adjusting a large set of parameters that may interact in terms of the sound equalization, is most likely not feasible to control by people not skilled in the art of sound equalization.

Consider the flexibility to offer both a simple and an advanced EQ (EQ configuration with varying degrees of freedom) in the same component/device/product/module etc. Generally, this may be provided by adjusting the number of bands of the EQ while still covering the entire bandwidth of operation, typically the audible range, i.e., about 20-20000 Hz. This is a coarse method, decreasing the number of bands (simpler EQ), will cause the bandwidth of each band to be comparably large. As a consequence of decreasing the number of bands, the EQ will be less effective at portraying minor details, it will typically be focused on peaks or dips at high frequencies and general adjustment at lower frequencies.

With the proposed solution, an underlying EQ processing is kept as advanced as required with a desired number of bands b₁,..., bₘ implemented either in time domain or in frequency domain (see more on that later). Substantially, only the presentation of the control points is changed according to the intention to present a simple or complex EQ.

The inventors behind the present disclosure have realized that it is possible to control a parametric EQ with any number m of bands b₁, ..., bₘ from a limited number n of EQ control indicators i₁, ..., iₙ (see Fig. 2a). Importantly, also where the number m of bands b₁, ..., bₘ is greater, even much greater, than the number n of EQ control indicators i₁, ..., iₙ, control parameters may be accurately provided.

In Fig. 2a, three EQ control indicators i₁, i₂, i₃ are shown. Each EQ control indicator i₁, i₂, i₃ comprises a frequency f and a gain G and are preferably tunable (configurable) with regards to both the frequency f and the gain G. Three EQ control indicators i₁, i₂, i₃ is a significantly low number of indicators to allow simple and yet accurate and efficient control of the EQ. However, embodiments with two or more EQ control indicators are well within the scope of the present disclosure.

From the EQ control indicators i₁, i₂, i₃, a polynomial EQ function p is provided, see Fig. 2b. The polynomial EQ function p may be provided by e.g., curve-fitting between the EQ control indicators i₁, i₂, i₃ in order to provide a smooth interconnection between the EQ control indicators i₁, i₂, i₃. The polynomial EQ function p may be described as presenting a preferred (wanted) gain G versus frequency f behavior of an associated audio EQ, that is to say *G = p*(*f*). The polynomial EQ function p may describe the gain G versus frequency f across a bandwidth of the associated EQ and/or across the frequency bands b₁, ..., bₘ of the associated EQ. Generally, the bandwidth of the EQ corresponds to a difference in frequency between a highest frequency of the frequency bands b₁, ..., bₘ and a lowest frequency of the frequency bands b₁, ..., bₘ.

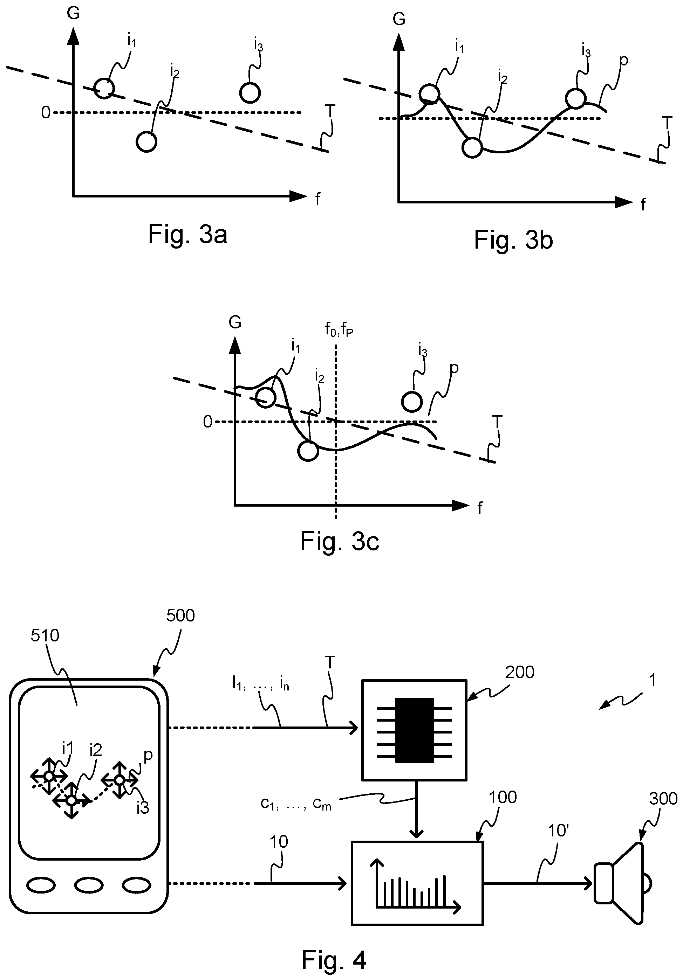

The polynomial EQ function p is a stand-alone, preferably continuous, function describing a preferred behavior of the EQ. As schematically shown in Fig. 2c, from the polynomial EQ function p, EQ control parameters c₁, ..., cₘ (see Fig. 4) of each band b₁, ...., bₘ of the EQ may be determined with regards to at least gain G and frequency f. If the bandwidth of each band b₁, ...., bₘ is predetermined (but not necessarily fixed to the same respective bandwidth), it is not required to comprise a bandwidth in the EQ control parameters c₁, ..., cₘ. It may be that some EQ control parameters c₁, ..., cₘ comprise a bandwidth and others don't. Further, some EQ control parameters c₁, ..., cₘ may comprise a Q-value. In Fig. 2d, the resulting EQ control parameters c₁, ..., cₘ are shown as provided to the EQ. In Fig. 2d, each EQ control parameter c₁, ..., cₘ is represented by one rectangle and the number m of EQ control parameters c₁, ..., cₘ is the same as the number of bands of the EQ. However, it may very well be that there are more or fewer EQ control parameters c₁, ..., cₘ than bands in the EQ. In such embodiments, e.g., interpolation (if fewer EQ control parameters c₁, ..., cₘ than bands) or averaging (if more EQ control parameters c₁, ..., cₘ than bands) may be employed in order to determine parameters for each band of the EQ.

In some embodiments, the number m of EQ control parameters c1, ..., cm are equal to a number of frequency bands of the EQ and the frequency f of each EQ control parameter c₁, ..., cₘ is associated with a corresponding frequency band b₁, ..., bₘ of the EQ.

In some embodiments, see Fig. 3a, a tilt indicator T may be provided in addition to the EQ control indicators i₁, i₂, i₃, or as a single control indicator of the EQ. The tilt indicator T preferably indicate a linear gain inclination for the EQ. That is to say, the tilt indicator T expresses a tilt that is to be applied to the polynomial EQ function p (if used). In embodiments wherein the tilt indicator T is utilized without the EQ control indicators i₁, i₂, i₃, the inclination indicated by the tilt indicator T will be the basis for the polynomial EQ function p as p = T*f + C where C is a constant. In Fig. 3a, the tilt indicator T is provided in conjunction with the same three EQ control indicators i₁, i₂, i₃ as in Figs. 2a-b.

As seen in Fig. 3b, the polynomial EQ function p is determined from the three EQ control indicators i₁, i₂, i₃. The EQ control indicators i₁, i₂, i₃ of Figs. 3a-c are the same as the EQ control indicators i₁, i₂, i₃ of Figs. 2a-c. Consequently, the polynomial EQ function p of Fig. 3b correspond to the polynomial EQ function p of Fig. 2b.

In Fig. 3c, the tilt indicator T is applied to the polynomial EQ function p such that it is tilted based on the tilt indicator T. Preferably, the tilt indicator T is applied such that a gain G at a center frequency f₀ of the EQ is unchanged. That is to say, the tilt indicator T is controlled by pivoting a linear tilt function about the center frequency f₀ of the EQ. In some embodiments, a pivot frequency fₚ about which the tilt indicator T controls the tilt of the polynomial EQ function p may be chosen freely within the bandwidth of the EQ. In Fig. 3c, the pivot frequency fₚ is equal to the center frequency f₀ of the EQ.

The tilt indicator T is beneficial as it allows a quick and simple means of e.g. quickly increasing a bass response and decreasing a treble response without having to change the EQ control indicators i₁, i₂, i₃. For instance, if a preferred setting of the EQ control indicators i₁, i₂, i₃ have been found, but a particular audio content is best enjoyed with reduced bass, a positive tilt indicator T may be applied such that the treble is increased and the bass is reduced.

By averaging a power frequency spectrum of a large number of musical songs, the power frequency spectrum of average music audio may be provided. The power frequency spectrum of average music audio generally exhibit higher amplitudes at mid and low frequencies compared to higher frequencies. This may be utilized when controlling a total audio power, total sound pressure level (SPL) (i.e. the total power provided across the full frequency spectrum) of the audio, specifically when the EQ control parameters c₁, ..., cₘ are applied to the EQ. Generally, in order to reduce a risk of clipping and/or saturation, a maximum allowable amplitude of the EQ control parameters c₁, ..., cₘ will be limited. As a result, a resulting SPL when the EQ control parameters c₁, ..., cₘ are applied will be lower than a an SPL provided without the EQ active. By normalizing the EQ control parameters c₁, ..., cₘ or the polynomial EQ function p by the power frequency spectrum of average music audio, a total SPL of the audio playback may be the same both when the EQ is active and when the EQ is inactive. To this end, the polynomial EQ function p may further be processed to (at least partly) compensate for the power frequency spectrum of average music audio.

It is known in the art that the perceived spectrum of sound differs with the SPL of the sound. This relation between SPL and perceived loudness is described by e.g., Fletcher-Munson curves or equal loudness contours. This means that, when a playback volume is changed, it may be that not only the total SPL of the audio changes, but also the perceived frequency response of the audio. In order to compensate for this, the EQ control parameters c₁, ..., cₘ or the polynomial EQ function p may be processed based on the equal loudness contours.

To exemplify the curve fitting, a user is presented with a number n of control indicators i₁, i₂, i₃ (n=3 in the preceding examples and Figs.) which may be used to shape a polynomial equalization curve i.e., the polynomial EQ function p. Commonly used equalization curves e.g., a smiley-curve has amplification in bass (e.g., 20-100 Hz) and treble (> 4-6 kHz) but not in middle register (1 - 3 kHz), another example is bass-boost where there is a clear boost at bass frequencies e.g., one control point at 100 Hz and a second at 200 Hz with less amplitude. The same is true for treble-boost where a first EQ control indicator i₁ indicate a first frequency of amplitude increase, and a second EQ control indicators i₂, and possible a third EQ control indicator i₃ indicate either a flat amplitude frequency band or a peak amplitude at e.g., 4-6 kHz for details.

Music is composed of many instruments and ranges over a large bandwidth where the instrument construction and usage determine the sound and thereby what frequencies are represented. In a temporal domain, a fundamental frequency is the most prominent component. However, a characteristic sound includes harmonic (or non-harmonic) components which are preferably considered when controlling amplitudes (gains) of different frequency components. If these components are not considered, the characteristics of the sound may change and the audio may sound differently than intended, not uncommonly the audio will sound badly. As an example, only amplifying the fundament of a bass-beat may lead to a perceived higher bass volume. But the beat may sound dull and less quick/peppy. The reason for this is that the harmonic components (higher frequencies than the fundamental) have not been adjusted correspondingly and does not contribute to a quick decay. Hence, the result is dull thumping sound instead of a quick bass-beat.

By selecting a position of an EQ control indicator i₁, i₂, i₃, the frequency f and gain G of the EQ control indicator i₁, i₂, i₃ may be translated into the purpose the user had. Several EQ control indicators i₁, i₂, i₃ in close position (i.e., close in frequency) may be combined. Two EQ control indicators i₁, i₂, i₃ may be determined to be adjacent if their associated frequencies f are comprised in adjacent or second to adjacent critical bands (CB) of the human hearing according to e.g., Equivalent Rectangular Bandwidth (ERB) division. The concept of ERB is known in the art and the skilled person knows how to utilize and compensate according to this.

The usage of ERB is not required, in some embodiments, it may be a Gammatone Filter bank of critical bands or equivalent model that describe the frequency resolution of the human hearing. The resolution of the CB may be chosen based on e.g., computation complexity. Common CB resolutions are one octave or 1/3 octave CBs. Octaves in human hearing are well known and the skilled person knows how to utilize and compensate according to this.

A modification of the amplitude in a frequency range of several CBs would generally result in a poorly detailed equalizer functionality. On the other hand, modifying the amplitude in just one CB may be poor for a temporal and/or tonal portraying (experience) of the sound.

Depending on the frequency of an EQ control indicator i₁, i₂, i₃, the number of CBs that are preferred to be included in the amplitude adjustment will vary, e.g., for low frequencies, the CBs are narrow and several of them must be included to adjust a sound with respect to fundamental and corresponding harmonics. This is one reason for the commonly utilized logarithmic representation of the frequency axis within present field of technology.

As an example, assuming e.g., a 1/3 octave CB division, for lower frequencies (<250 Hz) an EQ control indicator i₁, i₂, i₃ will adjust a magnitude (gain, amplitude) for at least three adjacent CB on either side of the CB corresponding to the frequency f of the EQ control indicator i₁, i₂, i₃. For low to middle and midrange frequencies (250 Hz-2 kHz), at least two adjacent bands are preferably used. for middle to high frequencies (2 - 6 kHz), one adjacent CB is preferably used and finally for high frequencies (> 6 kHz), the associated CB it-self is preferably used.

Knowing which CB to adjust according to the amplification given by the control-point amplitude, i.e., the gain G, may be utilized to select which polynomial approximation to utilize. There are several choices and the choice of approach may depend on a current situation.

Given that the gain G is high e.g., larger than 50% of an amplification scale, this will require a high boost and if there is no adjacent EQ control indicator i₁, i₂, i₃, the selection for curve fitting is preferably a second-order polynomial f(x)=+-(A-(x-x0)^2) due to its peak nature and smooth transition (positive or negative depending on amplification or attenuation, respectively).

If, on the other hand, there are adjacent CBs, the polynomial p may be of higher order e.g., 3 or 4 or higher order, such that the CB in between the selected EQ control indicator i₁, i₂, i₃ frequencies obtain an appropriate transition i.e., the transition in amplitude from one EQ control indicator i₁, i₂, i₃ to an adjacent EQ control indicator i₁, i₂, i₃ is monotonic.

Additionally, combinations of functions for description of a bandlimited (as described above) part of the frequency range may be e.g., a trigonometric function sin(x) or cos(x) as this family of function has desired properties of smoothness and are continuous. These are important properties, as is explained below, when a final EQ transfer function is composed from all the bandlimited sub-parts.

In combination, the set of control-points, with the selected polynomials as said above, describing the amplitude transfer function for a set of CB and including the CBs where no EQ control indicator i₁, i₂, i₃ are located are then processed (e.g., combined by a mathematical operation) to form a final amplitude transfer function in the frequency domain, i.e., the polynomial EQ function p.

Further, combination of one or several polynomials such that the intersection of their respective amplitude frequency transfer functions is continuous, may be achieved by e.g., a smoothing operation, a linearization operation, a fade-in-face out operation or combinations thereof.

The mathematic operation to combine the respective parts may be e.g., a weighted average function, the max operator or similar. The final amplitude transfer function, i.e., the polynomial EQ function p, is preferably provided as a continuous function without discontinuities i.e., mathematically smooth and first order differentiable and described over the equalizer frequency range of operation.

For sound quality, the smoothness and continuousness of the polynomial EQ function p will translate into a pleasant sound transformation. The polynomial EQ function p preferably lacks sharp peaks, dips and abrupt amplitude discontinuities. Sharp peaks, dips and abrupt amplitude discontinuities may cause both amplitude and phase variations that impact audio negatively. That is to say, a sharp amplitude change may cause a non-linear phase change in a time-domain EQ implementation and also fail to be represented correctly in amplitude.

As indicated above, the polynomial EQ function p may further be tilted according to the tilt indicator T. The purpose as previous described is to add additional weighting to a subset of frequencies. The tilt indicator T describes the degree of tilt and can be e.g., a linear gain frequency dependent gain where g(f,T,fₚ) = k(f,T,fₚ)+m(f,T,fₚ). Here k() and m() are the inclination and offset of the linear first order equation and depends on the tilt indicator T, frequency f and pivot frequency fₚ. This construction enables tilts in both negative and positive inclination at the rotation point, i.e., the pivot frequency fₚ.

The selection of pivot frequency fₚ where the tilt is centered, where g(fₚ)=1, preferably depend on the EQ control indicator i₁, i₂, i₃. Consider an example of the calculation of the pivot frequency fₚ as the median frequency over all control-points fₚ= median(f₁, f₂, ...). In another example, the pivot frequency fₚ is a center frequency of a given CB.

Optionally, a final amplitude frequency function may be applied in the EQ in one of several ways. The amplitude frequency function may be applied directly as a filter transfer function in a frequency convolution operation using an Overlap and Add method (overlap and add convolution is known from the art) where the input signal is divided into subframes with a given overlap, then transform into the frequency domain. Frequency samples are adjusted according to the amplitude frequency function, the result is added with part of a previous output and transformed back into time domain.

Secondly the amplitude transfer function may be transformed by an inverse Fourier transform into a linear phase finite impulse response filter representation that may be directly applied to the time domain input signal to for the output signal.

Additional representation includes e.g., minimum-phase transformation based on the linear phase finite impulse response representation above. Other representations are of course also feasable, but the frequency domain convolution is efficient in architectures with FFT accelerators, linear phase and minimum phase are representations that preserve relative temporal structure of the input signal after being processed.

In Fig. 4, a schematic view of an exemplary embodiment of an audio system 1 is shown. The audio system 1 comprises a processor circuit 200, an audio EQ 100 and an audio speaker arrangement 300. The processor circuit 200 is operatively connected to the audio EQ 100 that may be any suitable EQ. The audio EQ 100 is arranged to process an audio stream 10 which may be obtained e.g. across a communications interface, from a storage device, a microphone etc. Preferably, the audio stream 10 is a digital audio stream 10 and the audio EQ 100 is a digital EQ 100. The audio EQ 100 is operatively connected to the audio speaker arrangement 300. The processor circuit 200 is configured to obtain a number n of EQ control indicators i₁, ..., iₙ (or causes one or more other circuits, devices or modules to obtain the EQ control indicators i₁, ..., iₙ). Based on the EQ control indicators i₁, ..., iₙ and as presented herein, the processor circuit 200 curve-fits (or causes one or more other circuits, devices or modules to perform curve fitting) between the EQ control indicators i₁, ..., iₙ to provide the polynomial EQ function p (or cause one or more other circuits, devices or modules to provide the polynomial EQ function p). The processor circuit 200 is further configured to, based on the polynomial EQ function p, determine (or cause one or more other circuits, devices or modules to determine) a number m of EQ control parameters c₁, ..., cₘ. The EQ control parameters c₁, ..., cₘ may be any EQ control parameters c₁, ..., cₘ as presented herein. Preferably, the EQ control parameters c₁, ..., cₘ comprises a frequency f and a gain G. In some embodiments, one or more EQ control parameters c₁, ..., cₘ further comprises a Q-value and/or a bandwidth. The determined EQ control parameters c₁, ..., cₘ are provided to the EQ 100 and subsequently used by the EQ 100 to process (filter) the audio stream 10 to provide a processed audio stream 10'. The processed audio stream 10' is provided for playback by the audio speaker arrangement 300.

In some embodiments, the audio stream 10 is obtained, preferably wirelessly, from a user equipment 500. The user equipment 500 may be any suitable electronic device 500, preferably a portable electronic device 500 such as a mobile phone 500 or the like. In some embodiments, the user equipment 500 is comprised in the audio system 1.

In some embodiments, the EQ control indicators i₁, ..., iₙ are obtained from a user interface (UI) preferably a graphical UI (GUI) 510. If Fig. 4, the GUI is provided by the UE 500, this is one preferred embodiment, but the GUI may be provided by any suitable device e.g. a smart watch, a stationary computer, a tablet etc. i.e. any electronic device capable of providing a GUI, preferably a portable electronic device. In some embodiments, the GUI 510 presents the EQ control indicators i₁, ..., iₙ a amplitude versus frequency graph similar to what is shown in Fig. 2a and 2b. The frequency f and gain G of each EQ control indicator i₁, ..., iₙ be controlled by moving the respective EQ control indicator i₁, ..., iₙ a direction along a frequency axis of the graph, e.g. a horizontal direction to control frequency f, or a in a direction along the gain axis, e.g. a vertical direction to control the gain G. In some embodiments, the GUI 510 is a presented on a touch sensitive screen, i.e. a touchscreen, such that the EQ control indicatorsi₁, ..., iₙ may be moved (and thereby their associated gain G and frequency f controlled) by pulling them across the screen. The GUI 510 may be configured to only provide information on the EQ control indicators i₁, ..., iₙ, but preferably, the GUI 510 is further configured to obtain the polynomial EQ function p (or an indication thereof) such that the polynomial EQ function p may be shown on the GUI 510.

In some embodiments, the tilt indicator T is obtained from the GUI 510. In embodiments wherein the GUI 510 is provided on a touchscreen, the tilt indicator T may be controlled by e.g. long-pressing the screen, preferably by long-pressing the EQ function p is presented on the screen, and adjusting the desired inclination by movement in a direction along the gain axis, e.g. vertically. In further embodiments, the pivot frequency fₚ associated with the tilt indicator T may be adjusted (preferably after long-press as detailed above) by movement in a direction along the frequency axis, e.g. horizontally. In embodiments where the EQ function p is presented on the screen, the EQ function p is preferably updated to reflect the tilt indicated by the tilt indicator T.

Preferably, the control of the EQ 100 is such that any change made to the control indicators i₁, ..., iₙ leads to substantially instant update of the EQ 100. This allows a user of the audio system 1 to change (e.g., via the GUI 510) one of the control indicators i₁, ..., iₙ during playback of audio and immediately hear (experience) the how the updated control i₁, ..., iₙ affect the audio stream 10 in providing the processed audio stream 10'.

The components of the audio system 1 may be arranged in numerous configuration. To exemplify, in a preferred embodiment, the audio speaker arrangement 300 comprises both the processor device 200 and the EQ 100.

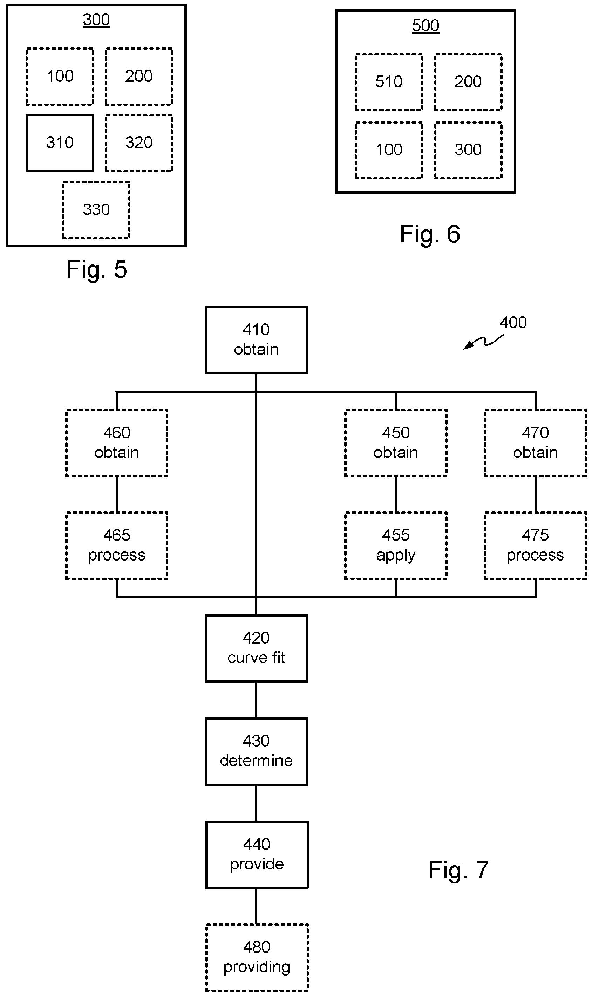

In some embodiments, the audio speaker arrangement 300 comprises one, or none of the processor device 200 or the EQ 100. This is schematically illustrated in Fig. 5 where an audio speaker arrangement 300 according to some embodiments is shown. The audio speaker arrangement 300 comprises at least one speaker 300; preferably the audio speaker arrangement 300 is a stereo audio speaker arrangement 300 and comprises two or more speakers 310. In some embodiments, the audio speaker arrangement 300 comprises one or more audio sensing circuits 320, e.g. microphones, configured to sense, measure or otherwise obtain audio in a vicinity of the audio speaker arrangement 300. The audio sensing circuits 320 may be configured to provide data for performing active noise cancellation (ANC) at the audio speaker arrangement 300. The audio speaker arrangement 300 may further comprise one or more communication circuits 330, preferably communication circuit 330 for wireless communication. The communication circuit 330 may be configured to communicate with e.g. the user equipment 510 and/or another communication circuit 330 of the audio speaker arrangement 300 e.g. for providing true wireless stereo (TWS).

As shown in Fig. 6, the user equipment 500 may, in some embodiments, comprise the processor circuit 200 and/or the EQ 100. In some embodiments, the user equipment comprises the audio speaker arrangement 300, this may be e.g. when enjoying audio from a speaker 310 of a mobile phone 500.

With reference to Fig. 7, a method 400 of controlling an audio EQ 100 will be introduced. The audio EQ 100 may be any suitable EQ known in the art or mentioned herein. The audio EQ 100 is arranged to process an audio stream 10 that may be e.g. the audio stream 10 as indicated with reference to Fig. 5. The method 400 may be performed/executed in any suitable order, and the orders in which the features are presented and illustrated in Fig. 7 are for explanatory purposes. However, as the skilled person will understand, some features are required in order to perform/provide other features.

The method 400 comprises obtaining 410 a number n of EQ control indicators i₁, ..., iₙ. These EQ control indicators i₁, ..., iₙ may be any EQ control indicators i₁, ..., iₙ presented herein and preferably each comprise a frequency f and a gain G. The EQ control indicators i₁, ..., iₙ may be obtained in any suitable way, e.g., provided from a GUI as presented herein, obtained across a communications interface, provided by a cloud server etc.

The method 400 further comprises curve fitting 420 between the EQ control indicators i₁, ..., iₙ, thereby providing a polynomial EQ function p. This may be performed in any suitable way, preferably as previously exemplified.

The method 400 further comprises determining 430 a number m of EQ control parameters c₁, ..., cₘ based on the polynomial EQ function p. This may be performed in any suitable way, preferably as previously exemplified. Preferably, each EQ control parameter c₁, ..., cₘ comprises a frequency f and a gain G. As mentioned, in some embodiments the EQ control parameter c₁, ..., cₘ may comprise a bandwidth and/or a Q-value. The number (n) of EQ control indicators i₁, ..., iₙis at least two (preferably at least three), and the number m of EQ control parameters c₁, ..., cₘ is greater than the number n of EQ control indicators i₁, ..., iₙ,

The method 400 further comprises providing 440 the determined EQ control indicators i₁, ..., iₙ to the audio EQ 100 (for subsequent use by the EQ 100 in processing audio).

In some embodiments, the method 400 further comprises obtaining 450 a tilt indicator T according to embodiments and/or examples previously presented herein. That is to say, the tilt indicator T indicates an additional linear gain inclination across the polynomial EQ function p and the method 400 further comprises applying 455 the tilt indicator T to the polynomial EQ function p. The tilt indicator T may be applied in any suitable manner, preferably as previously exemplified herein.

In some embodiments, the method 400 may further comprise obtaining 460 a power frequency spectrum of average music audio. This may be accomplished by averaging a number of music audio (songs) as previously presented herein. Further to this, the method 400 may comprise, as previously presented, processing 465 the polynomial EQ function p based on the power frequency spectrum.

In some embodiments, the method 400 may further comprise obtaining 470 a playback SPL indicator. The playback SPL indicator is indicative of a SPL used for playback of the audio stream 10. The method 400 may further comprise processing 475 the polynomial EQ function p or the EQ control parameter c₁, ..., cₘ based on the equal loudness contours associated with the SPL used for playback of the audio stream 10.

It should be mentioned, that the above presented method 400 may very well be extended to comprise further features, functions or examples presented herein. Also, the method may, as will be exemplified in the following, be wholly or partly performed by any suitable processor circuit, or arrangement of processor circuits. Specifically, the processor circuit 200 introduced with reference to Fig. 4 may be configured to perform, or cause other devices or circuits to perform, at least part of the method 400 of Fig. 7. The method 400 may be described as a computer implemented method 400.

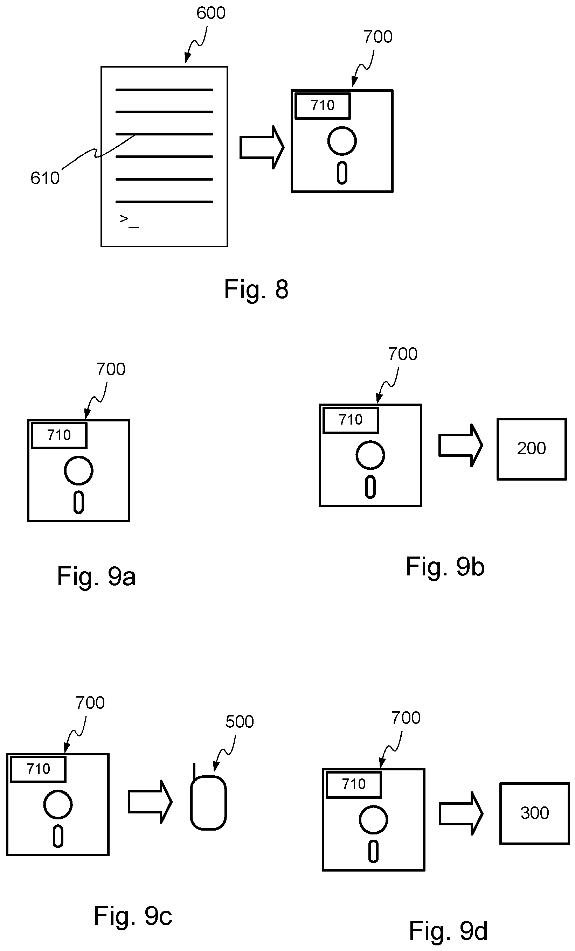

In Fig. 8, a computer program product 700 is shown. The computer program product 700 comprises a computer readable medium 710, in Fig. 8 exemplified as a vintage 5,25" floppy disc. Preferably, the computer readable medium 710 is a nonvolatile storage medium, exemplified, but not limited by, a computer readable disc (floppy, CD, DVD, etc.), a flash-memory or memory drive, etc. The computer readable medium 710 is provided with, i.e. it stores a computer program 600. The computer program 600 may be described as loaded onto, or written to, the computer readable medium 710. The computer program 600 comprises program instructions 610. These program instructions 610 are readable by a suitable processor circuit, e.g. the processor circuit 200 of Fig. 4. The program instructions 610 are configured to cause, when run by the processor circuit 200, the processor circuit 200 to perform the method 400 presented in reference to Fig. 7.

In Fig. 9a, the computer readable medium 710 is shown stand-alone.

In Fig. 9b, the computer readable medium 710 is loaded onto the processor circuit 200. When loaded onto the processor circuit 200, the processor circuit may execute the program instructions 610 and thereby perform, or cause other devices or circuits to perform, at least part of the method 400 presented with reference to Fig. 7.

In Fig. 9c, the computer readable medium 710 is loaded onto the portable electronic equipment 500. When loaded onto the portable electronic equipment 500, the portable electronic equipment 500 may execute the program instructions 610 and thereby perform, or cause other devices or circuits to perform, at least part of the method 400 presented with reference to Fig. 7.

In Fig. 9d, the computer readable medium 710 is loaded onto the audio speaker arrangement 300. When loaded onto the audio speaker arrangement 300, the audio speaker arrangement 300 may execute the program instructions 610 and thereby perform, or cause other devices or circuits to perform, at least part of the method 400 presented with reference to Fig. 7.

As the skilled person will appreciate, there may be further means of causing the processor circuit 200, the portable electronic equipment 500 and/or the audio speaker arrangement 300 to perform at least parts of the method 400 presented with reference to Fig. 7. Further, it may be that the method 400 is performed in a distributed manner such that to exemplify, some parts of the method 400 are performed by the audio speaker arrangement 300 and some parts of the method 400 are performed by the portable electronic equipment 500. Further, some parts of the (or the entire) method 400 may be performed by remote devices, such as a cloud server or cloud connected server (not shown).

The teachings of the present disclosure are presented with focus on the conceptual idea of controlling an EQ 100. Details and specific features well known to the skilled person are not included for efficiency of disclosure. For instance, conversion between analog and digital domains are not discussed as this may be performed in many different ways and does not directly affect the core of the present disclosure. However, it may be mentioned, without limitations to the scope, that the EQ 100 is preferably a digital EQ 100 and that most processing and filtering is performed in the digital domain.

Modifications and other variants of the described embodiments will come to mind to one skilled in the art having benefit of the teachings presented in the foregoing description and associated drawings. Therefore, it is to be understood that the embodiments are not limited to the specific example embodiments described in this disclosure and that modifications and other variants are intended to be included within the scope of this disclosure. For example, while embodiments of the invention have been described with reference to controlling an audio EQ, persons skilled in the art will appreciate that the embodiments of the invention can equivalently be applied to other control methods where a limited number of input data is used to provide a plurality of control parameters. Furthermore, although specific terms may be employed herein, they are used in a generic and descriptive sense only and not for purposes of limitation. Therefore, a person skilled in the art would recognize numerous variations to the described embodiments that would still fall within the scope of the appended claims. Furthermore, although individual features may be included in different claims (or embodiments), these may possibly advantageously be combined, and the inclusion of different claims (or embodiments) does not imply that a combination of features is not feasible and/or advantageous. In addition, singular references do not exclude a plurality. Finally, reference signs in the claims are provided merely as a clarifying example and should not be construed as limiting the scope of the claims in any way.

## Claims

1. A method (400) of controlling an audio equalizer, EQ, (100) arranged to process an audio stream (10), the method (400) comprising:
obtaining (410) a number (n) of EQ control indicators (i₁, ..., iₙ) for control of the audio EQ (100), each EQ control indicator (i₁, ..., iₙ) comprising a frequency (f) and a gain (G),
curve fitting (420) between the EQ control indicators (i₁, ..., iₙ), thereby providing a polynomial EQ function (p) describing a preferred gain (G) versus frequency (f) behavior of the audio EQ (100),
obtaining (450) a tilt indicator (T) indicating an additional linear gain inclination across the polynomial EQ function (p), and applying (455) the tilt indicator (T) to the polynomial EQ function (p),
determining (430) a number (m) of EQ control parameters (c₁, ..., cₘ) based on the polynomial EQ function (p), wherein each EQ control parameter (c₁, ..., cₘ) comprises a frequency (f) and a gain (G), and wherein the number (n) of EQ control indicators (i₁, ..., iₙ) is at least two, and the number (m) of EQ control parameters (c₁, ..., cₘ) is greater than the number (n) of EQ control indicators (i₁, ..., iₙ),
providing (440) the EQ control parameters (c₁, ..., cₙ) for control of the audio EQ (100).

2. The method (400) of claim 1, wherein the number (m) of EQ control parameters (c₁, ..., cₘ) are equal to a number of frequency bands of the EQ (100) and the frequency (f) of each EQ control parameter (c₁, ..., cₘ) is associated with a corresponding frequency band (b₁, ..., bₘ) of the audio EQ (100).

3. The method (400) of any one of the preceding claims, wherein the audio EQ is a parametric audio EQ and at least one of the EQ control parameters (c₁, ..., cₘ) comprises a bandwidth and/or a Q-value.

4. The method (400) of any one of the preceding claims, wherein the polynomial EQ function (p) is a polynomial function of second order.

5. The method (400) of any one of the preceding claims, further comprising, prior to determining (430) the number (m) of EQ control parameters (c₁, ..., cₘ), obtaining (460) a power frequency spectrum of average music audio and processing (465) the polynomial EQ function (p) based on the power frequency spectrum.

6. The method (400) of any one of the preceding claims, further comprising, prior to determining (430) the number (m) of EQ control parameters (c₁, ..., cₘ), obtaining (470) a playback sound pressure level, SPL, indicator indicative of a SPL used for playback of the audio stream (10) and processing (475) the polynomial EQ function (p) based on equal loudness contours.

7. The method (400) of any one of the preceding claims, wherein the EQ control indicators (i₁, ..., iₙ) are provided by a graphical user interface, GUI, (510) of a user equipment, UE (500), and the frequency (f) and the gain (G) of the EQ control indicators (i₁, ..., iₙ) are controllable via the GUI (510).

8. The method of claim 7, wherein the tilt indicator (T) is controllable via the GUI (510).

9. The method (400) of claim 7 or 8, further comprising, posterior to curve fitting (420) between the EQ control indicators (i₁, ..., iₙ), providing (480) the polynomial EQ function (p) for visualization on the GUI (510).

10. A processor circuit (200) operatively connected to an audio EQ (100) arranged to process an audio stream (10), the processor circuit (200) is configured to cause:
obtainment of a number (n) of EQ control indicators (i₁, ..., iₙ) for control of the audio EQ (100), each EQ control indicator (i₁, ..., iₙ) comprising a frequency (f) and a gain (G),
curve fitting between the EQ control indicators (i₁, ..., iₙ), thereby causing provisioning of a polynomial EQ function (p) describing a preferred gain (G) versus frequency (f) behavior of the audio EQ (100),
obtainment of a tilt indicator (T) indicating an additional linear gain inclination across the polynomial EQ function (p), and application of the tilt indicator (T) to the polynomial EQ function (p),
determining of a number (m) of EQ control parameters (c₁, ..., cₘ) based on the polynomial EQ function (p), wherein each EQ control parameter (c₁, ..., cₘ) comprises a frequency (f) and a gain (G), the number (n) of EQ control indicators (i₁, ..., iₙ) is at least two, and the number (m) of EQ control parameters (c₁, ..., cₘ) is greater than the number (n) of EQ control indicators (i1, ..., in),
provisioning of the EQ control parameters (c₁, ..., cₘ) for control of the audio EQ (100).

11. The processor circuit (200) of claim 10, further configured to cause execution of the method (400) of any one of claims 2 to 9.

12. An audio system (1) comprising the processor circuit (200) of claim 11, an audio speaker arrangement (300) and an audio EQ (100) arranged to filter an audio stream (10) for playback by the audio speaker arrangement (300), wherein the processor circuit (200) is operatively connected to the audio EQ (100) and the audio EQ (100) is operatively connected to the audio speaker arrangement (300).

13. The audio system (1) of claim 12, wherein the processor circuit (200) is comprised in a user equipment (5) of the audio system (1) and the audio EQ (100) is comprised in the audio speaker arrangement (300).

14. A computer program product (700) storing a computer program (600) comprising program instructions (610) readable by a processor circuit (200) and configured to cause, when run by the processor circuit (200), the processor circuit (200) to perform the method (400) according to any one of claims 1 to 9.

## Patentansprüche

1. Verfahren (400) zum Steuern eines Audio-Equalizers, EQ, (100), der dazu eingerichtet ist, einen Audiostream (10) zu verarbeiten, wobei das Verfahren (400) Folgendes umfasst:
Erhalten (410) einer Anzahl (n) von EQ-Steuerindikatoren (i₁, ..., iₙ) zur Steuerung des Audio-EQ (100), wobei jeder EQ-Steuerindikator (i₁, ..., iₙ) eine Frequenz (f) und eine Verstärkung (G) umfasst,
Kurvenanpassung (420) zwischen den EQ-Steuerindikatoren (i₁, ..., iₙ), wodurch eine polynomiale EQ-Funktion (p) bereitgestellt wird, die ein bevorzugtes Verstärkungs-(G-) gegenüber Frequenz-(f-)Verhalten des Audio-EQ (100) beschreibt,
Erhalten (450) eines Neigungsindikators (T), der eine zusätzliche lineare Verstärkungsneigung über die polynomiale EQ-Funktion (p) hinweg anzeigt, und Anwenden (455) des Neigungsindikators (T) auf die polynomiale EQ-Funktion (p),
Bestimmen (430) einer Anzahl (m) von EQ-Steuerparametern (c₁, ..., cₘ) auf Grundlage der polynomialen EQ-Funktion (p), wobei jeder EQ-Steuerparameter (c₁, ..., cₘ) eine Frequenz (f) und eine Verstärkung (G) umfasst, und wobei die Anzahl (n) der EQ-Steuerindikatoren (i₁, ..., iₙ) zumindest zwei beträgt und die Anzahl (m) der EQ-Steuerparameter (c₁, ..., cₘ) größer ist als die Anzahl (n) der EQ-Steuerindikatoren (i₁, ..., iₙ),
Bereitstellen (440) der EQ-Steuerparameter (c₁, ..., cₙ) zur Steuerung des Audio-EQ (100).

2. Verfahren (400) nach Anspruch 1, wobei die Anzahl (m) der EQ-Steuerparameter (c₁, ..., cₘ) gleich einer Anzahl von Frequenzbändern des EQ (100) ist und die Frequenz (f) jedes EQ-Steuerparameters (c₁, ..., cₘ) einem entsprechenden Frequenzband (b₁, ..., bₘ) des Audio-EQ (100) zugeordnet ist.

3. Verfahren (400) nach einem der vorhergehenden Ansprüche, wobei der Audio-EQ ein parametrischer Audio-EQ ist und zumindest einer der EQ-Steuerparameter (c₁, ..., cₘ) eine Bandbreite und/oder einen Q-Wert umfasst.

4. Verfahren (400) nach einem der vorhergehenden Ansprüche, wobei die polynomiale EQ-Funktion (p) eine polynomiale Funktion zweiter Ordnung ist.

5. Verfahren (400) nach einem der vorhergehenden Ansprüche, ferner umfassend, vor dem Bestimmen (430) der Anzahl (m) der EQ-Steuerparameter (c₁, ..., cₘ), das Erhalten (460) eines Leistungs-Frequenzspektrums durchschnittlicher Musikaudiosignale und das Verarbeiten (465) der polynomialen EQ-Funktion (p) auf Grundlage des Leistungs-Frequenzspektrums.

6. Verfahren (400) nach einem der vorhergehenden Ansprüche, ferner umfassend, vor dem Bestimmen (430) der Anzahl (m) der EQ-Steuerparameter (c₁, ..., cₘ), das Erhalten (470) eines Wiedergabe-Schalldruckpegel-Indikators, SPL, der einen für die Wiedergabe des Audiostreams (10) verwendeten SPL anzeigt, und das Verarbeiten (475) der polynomialen EQ-Funktion (p) auf Grundlage von Gleichlautheitskurven.

7. Verfahren (400) nach einem der vorhergehenden Ansprüche, wobei die EQ-Steuerindikatoren (i₁, ..., iₙ) durch eine grafische Benutzeroberfläche, GUI, (510) eines Benutzergeräts, UE, (500) bereitgestellt werden, und wobei die Frequenz (f) und die Verstärkung (G) der EQ-Steuerindikatoren (i₁, ..., iₙ) über die GUI (510) steuerbar sind.

8. Verfahren nach Anspruch 7, wobei der Neigungsindikator (T) über die GUI (510) steuerbar ist.

9. Verfahren (400) nach Anspruch 7 oder 8, ferner umfassend, nach der Kurvenanpassung (420) zwischen den EQ-Steuerindikatoren (i₁, ..., iₙ), das Bereitstellen (480) der polynomialen EQ-Funktion (p) zur Visualisierung auf der GUI (510).

10. Prozessorschaltung (200), die betriebsmäßig mit einem Audio-EQ (100) verbunden ist, der dazu eingerichtet ist, einen Audiostream (10) zu verarbeiten, wobei die Prozessorschaltung (200) dazu konfiguriert ist, Folgendes zu bewirken:
Erhalten einer Anzahl (n) von EQ-Steuerindikatoren (i₁, ..., iₙ) zur Steuerung des Audio-EQ (100), wobei jeder EQ-Steuerindikator (i₁, ..., iₙ) eine Frequenz (f) und eine Verstärkung (G) umfasst,
Kurvenanpassung zwischen den EQ-Steuerindikatoren (i₁, ..., iₙ), wodurch die Bereitstellung einer polynomialen EQ-Funktion (p) bewirkt wird, die ein bevorzugtes Verstärkungs-(G-) gegenüber Frequenz-(f-)Verhalten des Audio-EQ (100) beschreibt, das Erhalten eines Neigungsindikators (T), der eine zusätzliche lineare Verstärkungsneigung über die polynomiale EQ-Funktion (p) hinweg anzeigt, und das Anwenden des Neigungsindikators (T) auf die polynomiale EQ-Funktion (p),
Bestimmen einer Anzahl (m) von EQ-Steuerparametern (c₁, ..., cₘ) auf Grundlage der polynomialen EQ-Funktion (p), wobei jeder EQ-Steuerparameter (c₁, ..., cₘ) eine Frequenz (f) und eine Verstärkung (G) umfasst, wobei die Anzahl (n) der EQ-Steuerindikatoren (i₁, ..., iₙ) zumindest zwei beträgt und die Anzahl (m) der EQ-Steuerparameter (c₁, ..., cₘ) größer ist als die Anzahl (n) der EQ-Steuerindikatoren (i1, ..., in),
Bereitstellen der EQ-Steuerparameter (c₁, ..., cₘ) zur Steuerung des Audio-EQ (100).

11. Prozessorschaltung (200) nach Anspruch 10, ferner dazu konfiguriert, die Ausführung des Verfahrens (400) nach einem der Ansprüche 2 bis 9 zu bewirken.

12. Audiosystem (1), umfassend die Prozessorschaltung (200) nach Anspruch 11, eine Lautsprecheranordnung (300) und einen Audio-EQ (100), der dazu eingerichtet ist, einen Audiostream (10) zur Wiedergabe durch die Lautsprecheranordnung (300) zu filtern, wobei die Prozessorschaltung (200) betriebsmäßig mit dem Audio-EQ (100) verbunden ist und der Audio-EQ (100) betriebsmäßig mit der Lautsprecheranordnung (300) verbunden ist.

13. Audiosystem (1) nach Anspruch 12, wobei die Prozessorschaltung (200) in einem Benutzergerät (5) des Audiosystems (1) enthalten ist und der Audio-EQ (100) in der Lautsprecheranordnung (300) enthalten ist.

14. Computerprogrammprodukt (700), das ein Computerprogramm (600) speichert, das Programmanweisungen (610) umfasst, die von einer Prozessorschaltung (200) lesbar sind und dazu konfiguriert sind, beim Ausführen durch die Prozessorschaltung (200) die Prozessorschaltung (200) dazu zu veranlassen, das Verfahren (400) nach einem der Ansprüche 1 bis 9 auszuführen.

## Revendications

1. Procédé (400) de commande d'un égaliseur, EQ, (100) audio agencé pour traiter un flux audio (10), le procédé (400) comprenant :
l'obtention (410) d'un nombre (n) d'indicateurs de commande d'EQ (i₁, ..., iₙ) pour une commande de l'EQ (100) audio, chaque indicateur de commande d'EQ (i₁, ..., iₙ) comprenant une fréquence (f) et un gain (G),
l'ajustement de courbe (420) entre les indicateurs de commande d'EQ (i₁, ..., iₙ), fournissant ainsi une fonction EQ polynomiale (p) décrivant un comportement préféré gain (G)/fréquence (f) de l'EQ (100) audio,
l'obtention (450) d'un indicateur d'inclinaison (T) indiquant une inclinaison de gain linéaire supplémentaire sur la fonction EQ polynomiale (p), et l'application (455) de l'indicateur d'inclinaison (T) à la fonction EQ polynomiale (p),
la détermination (430) d'un nombre (m) de paramètres de commande d'EQ (c₁, ..., cₘ) sur la base de la fonction EQ polynomiale (p), dans lequel chaque paramètre de commande d'EQ (c₁, ..., cₘ) comprend une fréquence (f) et un gain (G), et dans lequel le nombre (n) d'indicateurs de commande d'EQ (i₁, ..., iₙ) est d'au moins deux, et le nombre (m) de paramètres de commande d'EQ (c₁, ..., cₘ) est supérieur au nombre (n) d'indicateurs de commande d'EQ (i₁, ..., iₙ),
la fourniture (440) des paramètres de commande d'EQ (c₁, ..., cₙ) pour une commande de l'EQ (100) audio.

2. Procédé (400) selon la revendication 1, dans lequel le nombre (m) de paramètres de commande d'EQ (c₁, ..., cₘ) est égal à un nombre de bandes de fréquences de l'EQ (100) et la fréquence (f) de chaque paramètre de commande d'EQ (c₁, ..., cₘ) est associée à une bande de fréquences (b₁, ..., bₘ) correspondante de l'EQ (100) audio.

3. Procédé (400) selon l'une quelconque des revendications précédentes, dans lequel l'EQ audio est un EQ audio paramétrique et au moins un parmi les paramètres de commande d'EQ (c₁, ..., cₘ) comprend une largeur de bande et/ou une valeur Q.

4. Procédé (400) selon l'une quelconque des revendications précédentes, dans lequel la fonction EQ polynomiale (p) est une fonction polynomiale de deuxième ordre.

5. Procédé (400) selon l'une quelconque des revendications précédentes, comprenant en outre, avant la détermination (430) du nombre (m) de paramètres de commande d'EQ (c₁, ..., cₘ), l'obtention (460) d'un spectre de fréquence de puissance d'audio musical moyen et le traitement (465) de la fonction EQ polynomiale (p) sur la base du spectre de fréquence de puissance.

6. Procédé (400) selon l'une quelconque des revendications précédentes, comprenant en outre, avant la détermination (430) du nombre (m) de paramètres de commande d'EQ (c₁, ..., cₘ), l'obtention (470) d'un indicateur de niveau de pression acoustique, SPL, de lecture indiquant un SPL utilisé pour une lecture du flux audio (10) et le traitement (475) de la fonction EQ polynomiale (p) sur la base de courbes isosoniques.

7. Procédé (400) selon l'une quelconque des revendications précédentes, dans lequel les indicateurs de commande d'EQ (i₁, ..., iₙ) sont fournis par une interface utilisateur graphique, GUI, (510) d'un équipement utilisateur, UE, (500), et la fréquence (f) et le gain (G) des indicateurs de commande d'EQ (i₁, ..., iₙ) peuvent être commandés via la GUI (510).

8. Procédé selon la revendication 7, dans lequel l'indicateur d'inclinaison (T) peut être commandé via la GUI (510).

9. Procédé (400) selon la revendication 7 ou 8, comprenant en outre, après l'ajustement de courbe (420) entre les indicateurs de commande d'EQ (i₁, ..., iₙ), la fourniture (480) de la fonction EQ polynomiale (p) pour une visualisation sur la GUI (510).

10. Circuit processeur (200) connecté fonctionnellement à un EQ (100) audio agencé pour traiter un flux audio (10), le circuit processeur (200) est configuré pour provoquer :
l'obtention d'un nombre (n) d'indicateurs de commande d'EQ (i₁, ..., iₙ) pour une commande de l'EQ (100) audio, chaque indicateur de commande d'EQ (i₁, ..., iₙ) comprenant une fréquence (f) et un gain (G),
l'ajustement de courbe entre les indicateurs de commande d'EQ (i₁, ..., iₙ), provoquant ainsi la fourniture d'une fonction EQ polynomiale (p) décrivant un comportement préféré gain (G)/fréquence (f) de l'EQ (100) audio,
l'obtention d'un indicateur d'inclinaison (T) indiquant une inclinaison de gain linéaire supplémentaire sur la fonction EQ polynomiale (p), et l'application de l'indicateur d'inclinaison (T) à la fonction EQ polynomiale (p),
la détermination d'un nombre (m) de paramètres de commande d'EQ (c₁, ..., cₘ) sur la base de la fonction EQ polynomiale (p), dans lequel chaque paramètre de commande d'EQ (c₁, ..., cₘ) comprend une fréquence (f) et un gain (G), le nombre (n) d'indicateurs de commande d'EQ (i₁, ..., iₙ) est d'au moins deux, et le nombre (m) de paramètres de commande d'EQ (c₁, ..., cₘ) est supérieur au nombre (n) d'indicateurs de commande d'EQ (il, ..., in),
la fourniture des paramètres de commande d'EQ (c₁, ..., cₘ) pour une commande de l'EQ (100) audio.

11. Circuit processeur (200) selon la revendication 10, configuré en outre pour provoquer l'exécution du procédé (400) selon l'une quelconque des revendications 2 à 9.

12. Système audio(1) comprenant le circuit processeur (200) selon la revendication 11, un agencement de haut-parleur audio (300) et un EQ (100) audio agencé pour filtrer un flux audio (10) pour une lecture par l'agencement de haut-parleur audio (300), dans lequel le circuit processeur (200) est connecté fonctionnellement à l'EQ (100) audio et l'EQ (100) audio est connecté fonctionnellement à l'agencement de haut-parleur audio (300).

13. Système audio (1) selon la revendication 12, dans lequel le circuit processeur (200) est compris dans un équipement utilisateur (5) du système audio (1) et l'EQ (100) audio est compris dans l'agencement de haut-parleur audio (300).

14. Produit programme d'ordinateur (700) stockant un programme d'ordinateur (600) comprenant des instructions de programme (610) lisibles par un circuit processeur (200) et configurées pour amener, lorsqu'elles sont exécutées par le circuit processeur (200), le circuit processeur (200) à réaliser le procédé (400) selon l'une quelconque des revendications 1 à 9.
